# EUROPEAN PATENT SPECIFICATION

(11) **EP 1 887 100 B1**
(45) Date of publication and mention of the grant of the patent: **11.05.2011**
(21) Application number: 06729368.8
(22) Date of filing: 17.03.2006
(51) Int. Cl.: C23C 14/34, C04B 35/453, G11B 7/254, G11B 7/257, G11B 7/26

(54) **SPUTTERING TARGET AND PROCESS FOR PRODUCING THE SAME**
SPUTTERTARGET UND HERSTELLUNGSVERFAHREN DAFÜR
CIBLE DE PULVÉRISATION CATHODIQUE ET PROCÉDÉ DE FABRICATION IDOINE

(30) Priority: 30.05.2005 JP 2005156646
(43) Date of publication of application: 13.02.2008
(73) Proprietor: Nippon Mining & Metals Co., Ltd., Minato-ku Tokyo 105-0001 (JP)
(72) Inventor: NAKAMURA, A., c/o Nippon Mining & Metals Co., Ltd., Kitaibaraki-shi, Ibaraki 319-1535 (JP); YAHAGI, M., c/o Nippon Mining & Metals Co., Ltd., Kitaibaraki-shi, Ibaraki 319-1535 (JP); SATO, K., c/o Nippon Mining & Metals Co., Ltd., Kitaibaraki-shi, Ibaraki 319-1535 (JP)
(74) Representative: Hoarton, Lloyd Douglas Charles
(86) International application number: PCT/JP2006/305378
(87) International publication number: WO 2006/129410

(56) References cited:
- JP-A- 03 050 148
- JP-A- 11 322 332
- JP-A- 11 322 413
- JP-A- 2000 119 062
- JP-A- 2003 105 533
- JP-A- 2004 263 273

## Description

### TECHNICAL FIELD

The present invention relates to a target for forming an optical thin film that does not contain sulfur, has low bulk resistance and enables DC sputtering, and has a low refractive index.

### BACKGROUND ART

Conventionally, ZnS-SiO₂ generally and primarily used as protective layers of a phase change optical information recording medium has superior characteristics such as in optical characteristics, heat characteristics, and adhesiveness with the recording layer, and is being widely used.

Nevertheless, rewritable DVDs in the present day as represented by Blu-ray discs are strongly demanded of more write cycles, greater capacity, and faster recording.

As one reason for deterioration in the write cycles of an optical information recording medium, there is the diffusion of a sulfur constituent from the ZnS-SiO₂ to the recording layer material disposed in between the protective layers formed from ZnS-SiO₂.

Further, although pure Ag or Ag alloy having high thermal conduction properties with a high reflection ratio is being used as the reflective layer material for realizing high capacity and high-speed recording, this kind of reflective layer is also disposed to come in contact with the protective layer material of ZnS-SiO₂.

Therefore, in this case also, as a result of diffusion of the sulfur constituent from the ZnS-SiO₂, the pure Ag or Ag alloy reflective layer material is subject to corrosive degradation, and would cause the characteristic degradation in the reflection ratio of the optical information recording medium.

As a measure for preventing the diffusion of such sulfur constituent, attempts have been made to provide an intermediate layer having nitrides or carbides as its primary component between the reflective layer and protective layer, and between the recording layer and protective layer. Nevertheless, this results in an increased number of layers, and there is a problem in that the throughput will deteriorate and costs will increase.

In order to overcome the foregoing problems, consideration is being given to substituting the material with an oxide material that does not contain sulfides in the protective layer material, having optical characteristics and amorphous stability that are equivalent to or better than ZnS-SiO₂.

Further, since a ceramic target of ZnS-SiO₂ or the like has high bulk resistance, it is not possible to perform deposition with a DC sputtering device, and a radio frequency sputtering (RF) device is generally used.

In reality, not only is this radio frequency sputtering (RF) device an expensive device, it has numerous drawbacks in that the sputtering efficiency is inferior, power consumption is significant, control is difficult, and deposition speed is slow.

Moreover, when high power is applied to increase the deposition speed, there is a problem in that the substrate temperature will rise, and a polycarbonate substrate would deform. Also, there are additional problems in that the throughput will decrease and costs will increase since the film thickness of ZnS-SiO₂ is thick.

In light of the above, proposed is a sintered compact target obtained by using ZnO; more specifically, independently adding an element having an atomic valence of trivalent and more to ZnO in order to form a transparent conductive thin film without containing any sulfur component (for instance, refer to Patent Document 1). This technology, however, is not able to sufficiently strike a balance between the bulk resistance and achieving a low refractive index.

In addition, proposed is a manufacturing method employing an RF or DC magnetron sputtering method that variously combines group II, III and IV elements for obtaining a transparent conductive film and a sintered compact for manufacturing such a transparent conductive film (refer to Patent Document 2). The object of this technology, however, is not to achieve the low resistance of a target, and this technology is not able to sufficiently strike a balance between the bulk resistance and achieving a low refractive index.

Also proposed is a ZnO sputtering target including a condition where at least one type of element to be added is dissolved in ZnO (refer to Patent Document 3). Since this technology is subject to the condition of the additive element being dissolved, there are restrictions to the component composition. Thus, there is a problem in that the optical characteristics will also be restricted as well.
[Patent Document 1] Japanese Patent Laid-Open Publication No. H2-149459
[Patent Document 2] Japanese Patent Laid-Open Publication No. H 8-264022
[Patent Document 3] Japanese Patent Laid-Open Publication No. H 11-322332

### DISCLOSURE OF THE INVENTION

The object of the present invention is to provide a target for forming an optical thin film with a low refractive index and its manufacturing method, which does not contain sulfur, has low bulk resistance and enables DC sputtering by choosing appropriate materials. It is also to provide a sputtering target and its manufacturing method, which is useful in forming a thin film in optical information recording medium (especially used as a protective film) where the adjacent recording layer and reflective layer are hardly deteriorated, since the invented film is superior in adhesiveness with the recording layer, mechanical properties and transmission factor and it is composed with a non-sulfide system. As a result, the present invention aims to improve the characteristics of the optical information recording medium, reduce the facility costs, and considerably improve the throughput by improving the deposition speed.

In order to achieve the foregoing objects, as a result of intense study, the present inventors discovered that, by substituting the conventional protective layer material of ZnS-SiO₂ with an oxide material presented below that does not contain sulfides, it is possible to ensure optical characteristics and amorphous stability that are equivalent to or better than ZnS-SiO₂, and it is further possible to realize high-speed deposition using DC (Direct Current) sputtering while improving the characteristics of the optical information recording medium and improving the productivity. In addition, the present inventors discovered that RF sputtering can be performed as necessary, characteristics of the optical information recording medium can be improved, and the productivity can also be improved.

Based on the foregoing discovery, the present invention provides a sputtering target comprised of 0.2 to 3.0 at% of Al₂O₃, 1 to 27 at% of MgO and/or SiO₂, and remnant ZnO, and having a low bulk resistance.

As a method of manufacturing the target of the present invention, it is effective to preliminarily mix and preliminarily calcinate Al₂O₃ powder and ZnO powder as the raw material, subsequently mix MgO and/or SiO₂ powder as the additive materials to the calcinated Al₂O₃-ZnO powder (AZO powder), calcinate the obtained power once again, and thereafter sinter said obtained powder.

In the foregoing case, it is also effective to similarly mix and calcinate MgO powder and SiO₂ powder as the additive raw material, subsequently mix the MgO-SiO₂ calcinated powder to said calcinated Al₂O₃-ZnO powder (AZO powder), calcinate the obtained power once again, and thereafter sintering said obtained powder. With the sputtering target obtained as described above, it will be easy to obtain a target having a relative density of 90% or higher and a bulk resistance that is less than 100m Ω· cm. The present invention is useful as a target for forming a protective layer of an optical information recording medium.

### Effect of the Invention

As a result of the above, by substituting the protective layer material of ZnS-SiO₂ with an oxide material that does not contain sulfides, it is possible to inhibit the deterioration of the adjacent reflective layer and recording layer caused by sulfur, realize optical characteristics that are equal to or better than ZnS-SiO₂, and enable high speed deposition by reducing the bulk resistance. The present invention is also able to provide to a sputtering target that is effective in forming a thin film for an optical information recording medium (especially used as a protective film, a reflective layer, or a semitransparent film layer) that has superior characteristics such as being superior in adhesiveness and mechanical properties with the recording layer, and having a high transmission factor. As described above, the present invention yields superior effects in being able to improve the characteristics of an optical information recording medium, reduce the facility costs, and significantly improve the throughput by increasing the deposition speed.

### BEST MODE FOR CARRYING OUT THE INVENTION

The sputtering target of the present invention is comprised of 0.2 to 3,0 at% of Al₂O₃, 1 to 27 at% of MgO and/or SiO₂, and remnant ZnO, and has a low bulk resistance. In other words, Al₂O₃ that provides conductivity and at least one type of MgO and SiO₂ for adjusting the refractive index are dispersed in ZnO.

If Al₂O₃ is less than 0.2 at%, the bulk resistance will increase, and the object of the present invention cannot be achieved. If Al₂O₃ exceeds 3.0 at%, this is not preferable since the bulk resistance will increase, and it will not be possible to perform DC sputtering.

MgO and SiO₂ may be added independently or together in order to achieve the object of the present invention. If the MgO and/or SiO₂ content is less than 1 at%, it is not possible to achieve a low refractive index, and, if such content exceeds 27 at%, this is not preferable since the bulk resistance will increase, and the deposition speed will significantly decrease. Therefore, it is preferable that the components are within the foregoing composition range.

It is even more preferable to add MgO and/or SiO₂ in the amount of 10 to 27 at%. This is because, in comparison to the case where the additive amount of MgO and/or SiO₂ is 1 to 10 at%, the case of adding 10 to 27 at% further improves the transmission factor and reduces the refractive index.

This sputtering target is particularly useful for industrially manufacturing an optical thin film for use in an optical disk having a low refractive index; a refractive index of 1.5 to 1.75 (633nm). Specifically, this sputtering target may be used as a target for forming a protective layer, a reflective layer or a semitransparent layer of an optical information recording medium.

Pursuant to the increase in capacity of optical information recording mediums, DVD-Rs and DVD-RWs compatible with multilayer recording have appeared in the market. When adopting this kind of multilayer structure, the reflective layer of the first layer positioned between the first layer and the second layer is required to possess transparency for irradiating recording/reading light to the second layer. When using Ag alloy as this kind of semitransparent layer, there is a problem of sulfurization caused by the reaction with ZnS-SiO₂ used as the protective layer.

As a semitransparent layer that does not entail such problem of sulfurization, it is possible to use a semitransparent layer having arbitrary optical characteristics by alternately laminating a high refractive index layer and a low refractive index layer. The target of the present invention may also be preferably used as a low refractive index layer configuring the semitransparent layer in addition to the foregoing protective layer.

The bulk resistance of the target is able to achieve a value that is less than 1 00m Ω·cm. As a result of reducing the bulk resistance, high speed deposition using DC sputtering is enabled. Although RF sputtering will be required depending on the type of material selected, the deposition speed can also be improved in this case of performing RF sputtering.

As a result of the above, the sputtering deposition speed and optical characteristics (refractive index, transmission factor) will be within the optimal range. Numerical values that deviate from the foregoing range tend to be inferior to the foregoing characteristics.

The present invention also proposes preliminarily mixing and preliminarily calcinating Al₂O₃ powder and ZnO powder as the raw material, subsequently mixing MgO and/or SiO₂ powder to the calcinated Al₂O₃-ZnO powder (AZO powder), calcinating the obtained power once again, and thereafter sintering said obtained powder. If the MgO and/or SiO₂ powder is merely added, Al₂O₃ and MgO and/or SiO₂ will react and easily become a spinel, and the bulk resistance tends to increase. Thus, in order to achieve a lower bulk resistance of the sintered compact, it is desirable to perform sintering using the calcinated Al₂O₃-ZnO powder (AZO powder).

The present invention further recommends preliminarily mixing and preliminarily calcinating Al₂O₃ powder and ZnO powder as the raw material, similarly mixing and calcinating MgO powder and SiO₂ powder as the raw material, subsequently mixing the MgO-SiO₂ calcinated powder to said calcinated Al₂O₃-ZnO powder (AZO powder), calcinating the obtained power once again, and thereafter sintering said obtained powder. It is thereby possible to further inhibit a spinel and to achieve a low bulk resistance.

Further, the sputtering target of the present invention is able to achieve a relative density of 90% or higher. The improvement in density yields an effect of improving the uniformity of the sputtered film and inhibiting the generation of particles during sputtering.

The sputtering target described above can be used at least as a thin film in forming a part of an optical information recording medium structure to provide an optical information recording medium. Further, the foregoing sputtering target can be used at least as a thin film in forming a part of an optical information recording medium structure, and disposed adjacent to a recording layer or a reflective layer.

As a result of using a target having zinc oxide as its primary component, the present invention is able to possess conductivity, and form a thin film using direct current sputtering (DC sputtering). In comparison to RF sputtering, DC sputtering is superior in that the deposition speed is high, sputtering efficiency is favorable, and it is possible to improve throghput significantly. Further, a DC sputtering device has advantages in that it is inexpensive, easy to control, and requires less power. Further, since it will be possible to thinly form the film thickness of the protective film itself by adjusting the optical characteristics, it will be possible to exhibit further effects of improving the productivity and preventing the heating of the substrate. Although there may be cases in the present invention where RF sputtering must be performed depending on the manufacturing conditions and selected material, the deposition speed can still be improved in such cases where RF sputtering is performed.

Moreover, the thin film formed using the sputtering target of the present invention forms a part of the optical information recording medium structure and is disposed adjacent to the recording layer or reflective layer, but as described above, since ZnS is not used, there is no contamination by S, there is no diffusion of the sulfur constituent to the recording layer material disposed between the protective layers, and there is a significant effect in that the deterioration of the recording layer can be prevented thereby.

Further, when using pure Ag or Ag alloy having high thermal conduction properties at a high reflection ratio as adjacent reflective layers for realizing high capacity and high-speed recording, diffusion of the sulfur constituent to such adjacent reflective layers will not occur, and a superior effect is yielded in that the cause of the reflective layer material being subject to corrosive degradation and causing characteristic degradation in the reflection ratio of the optical information recording medium can be cleared out.

The sputtering target of the present invention can be manufactured by subjecting the oxide powder of the respective constituent elements, in which the average grain size is 5µm or less, to pressureless sintering or high temperature pressure sintering. It is thereby possible to obtain a sputtering target having a relative density of 90% or higher. In such a case, it is desirable to calcinate the oxide powder having zinc oxide as its primary component at a temperature of 800 to 1200°C before sintering. After this calcination, the resultant powder is pulverized to 3µm or less and used as the raw material for sintering.

Further, by using the sputtering target of the present invention, a significant effect is yielded in that it is possible to improve the productivity, obtain a high-quality material, and stably manufacture an optical recording medium having an optical disk protective film at low costs.

Improvement in the density of the sputtering target of the present invention reduces holes and miniaturizes crystal grains, and enables the sputtered face of the target to become uniform and smooth. As a result, a significant result is yielded in that particles and nodules generated during sputtering can be reduced, the target life can be extended, and the mass productivity can be improved with minimal variation in the quality.

### [Examples]

Examples and Comparative Examples of the present invention are now explained. These Examples are merely illustrative, and the present invention shall in no way be limited thereby. In other words, the present invention shall only be limited by the scope of the present invention, and shall include the various modifications other than the Examples of this invention.

### (Example 1)

ZnO powder equivalent of 4N and 5µm or less, Al₂O₃ powder equivalent of 4N and having an average grain size of 5µm or less, and MgO powder equivalent of 4N and having an average grain size of 5µm or less were prepared. Subsequently, the ZnO powder and the Al₂O₃ powder were mixed to achieve the compounding ratio shown in Table 1, and the mixed powder was calcinated at a temperature of 1000°C to obtain AZO powder.

The foregoing AZO [powder] and the MgO powder were mixed to achieve the compounding ratio shown in Table 1, and further calcinated at a temperature of 1000°C. The obtained calcinated powder was pulverized with a ball mill or the like to an average grain size of 1µm or less, and thereafter granulated to increase the moldability, The granulated powder material was press molded at a pressure of 500kgf/cm².

After press molding, the resultant material was subject to pressureless sintering in an oxygen atmosphere at a temperature of 1400°C. This sintered material was formed into a target with machining process.

The foregoing 6-inch φ size target subject to finish processing was used to perform sputtering. The sputtering conditions were DC sputtering, sputtering power of 500W, and Ar gas pressure of 0.5Pa, and deposition was performed to achieve a film thickness of 1500Å.

Results of the measured transmission factor % (wavelength 633nm) and refractive index (wavelength 633nm) as well as the sputtering method and deposition speed (Å/sec) of the deposition sample are collectively shown in Table 1.

**[Table 1]**

| Examples | Constituents | Composition No. of at% | Calcination Step3ulk | Resistance mO·cm | Transmission 633nm (%) | Factor Refractive Index 633nm | Deposition Speed Å/sec |
|---|---|---|---|---|---|---|---|
| Example 1 | ZnO | 79 | 2 | 60 | 97.9 | 1.73 | 1.8 |
| | Al2O3 | 1.3 | | | | | (DC Sputtering) |
| | MgO | 19.7 | | | | | |
| Example 2 | ZnO | 72 | 3 | 38 | 98.7 | 1.7 | 1.7 |
| | Al2O3 | 1.2 | | | | | (DC Sputtering) |
| | MgO | 24.6 | | | | | |
| | SiO2 | 2.2 | | | | | |
| Example 3 | ZnO | 88 | 2 | 35 | 98.5 | 1.75 | 2 |
| | Al2O3 | 1.5 | | | | | |
| | MgO | 10.5 | | | | | |
| Example 4 | ZnO | 88 | 2 | 45 | 99.4 | 1.7 | 2.2 |
| | Al2O3 | 1.6 | | | | | |
| | SiO2 | 10.4 | | | | | |
| Example 5 | ZnO | 88.4 | 3 | 50 | 97.4 | 1.78 | 1.9 |
| | Al2O3 | 1.7 | | | | | |
| | MgO | 5.4 | | | | | |
| | SiO2 | 4.5 | | | | | |
| Example 6 | ZnO | 97.5 | 2 | 30 | 95.8 | 1.82 | 2.2 |
| | Al2O3 | 2.5 | | | | | |
| | MgO | 1 | | | | | |
| Example 7 | ZnO | 97.3 | 3 | 30 | 96.9 | 1.82 | 2.5 |
| | Al2O3 | 2.4 | | | | | |
| | MgO | 0.5 | | | | | |
| | SiO2 | 0.5 | | | | | |
| Example 8 | ZnO | 79 | 1 | 120 | 97.5 | 1.74 | 0.9 |
| | Al2O3 | 1.3 | | | | | (RF Sputtering) |
| | MgO | 19.7 | | | | | |
| Example 9 | ZnO | 72 | 1 | 250 | 98.8 | 1.7 | 0.8 |
| | Al2O3 | 1.2 | | | | | (RF Sputtering) |
| | MgO | 24.6 | | | | | |
| | Si02 | 2.2 | | | | | |
| | | | | | | | |
| Comparative Example 1 | ZnO | 98.4 | 1 | 20 | 97.5 | 1.84 | 2.2 |
| | Al2O3 | 1.6 | | | | | |
| Comparative Example 2 | ZnO | 70 | 2 | 450 | 98.1 | 1.69 | 0.4 |
| | Al2O3 | 0.9 | | | | | |
| | MgO | 29.1 | | | | | |
| Comparative Example 3 | ZnO | 68.2 | 3 | 750 | 99.7 | 1.67 | 0.5 |
| | Al2O3 | 0.9 | | | | | |
| | MgO | 19.1 | | | | | |
| | SiO2 | 11.8 | | | | | |

As a result of the above, the sputtering target of Example 1 achieved a relative density of 95%, and stable DC sputtering could be performed. The bulk resistance was 60m Ω·cm, the deposition speed achieved 1.8Å/sec, and showed favorable sputtering characteristics. The transmission factor of the sputtered film achieved 97.9% (633nm), and the refractive index was 1.73.

Since the target of this Example does not use ZnS, there is no characteristic degradation in the optical information recording medium caused by the diffusion or contamination of sulfur. Further, in comparison to the Comparative Examples described later, the transmission factor, refractive index, target density and deposition speed of the deposition sample all showed favorable numerical values, and it was possible to perform DC sputtering.

### (Example 2)

ZnO powder equivalent of 4N and 5µm or less, Al₂O₃ powder equivalent of 4N and having an average grain size of 5µm or less, and SiO₂ powder and MgO powder equivalent of 4N and having an average grain size of 5µm or less were prepared. Subsequently, the ZnO powder and the Al₂O₃ powder were mixed to achieve the compounding ratio shown in Table 1, and the mixed powder was calcinated at a temperature of 1000°C to obtain AZO powder.

Meanwhile, the MgO powder equivalent of 4N and having an average grain size of 5µm or less and the SiO₂ powder equivalent of 4N and having an average grain size of 5µm or less were similarly mixed to achieve the compounding ratio shown in Table 1, and the mixed powder was further calcinated at a temperature of 1000°C.

Subsequently, the foregoing AZO powder and the calcinated powder of MgO powder and SiO₂ powder were further mixed and calcinated once again. The obtained calcinated powder was pulverized with a ball mill or the like to an average grain size of 1µm or less, and thereafter granulated to increase the moldability. The granulated powder material was press molded at a pressure of 500kgf/cm².

After press molding, the resultant material was subject to pressureless sintering in an oxygen atmosphere at a temperature of 1400°C. This sintered material was formed into a target with machining process.

The foregoing 6-inch φ size target subject to finish processing was used to perform sputtering. The sputtering conditions and evaluation method were the same as Example 1. The results are similarly shown in Table 1.

As a result of the above, the sputtering target of Example 2 achieved a relative density of 95%, and stable DC sputtering could be performed. The bulk resistance was 38m Ω·cm, the deposition speed achieved 1.7Å/sec, and showed favorable sputtering characteristics.

The transmission factor of the sputtered film achieved 98.7% (633nm), and the refractive index was 1.7.

Since the target of this Example does not use ZnS, there is no characteristic degradation in the optical information recording medium caused by the diffusion or contamination of sulfur. Further, in comparison to the Comparative Examples described later, the transmission factor, refractive index, target density and deposition speed of the deposition sample all showed favorable numerical values, and it was possible to perform DC sputtering.

### (Example 3)

ZnO powder equivalent of 4N and 5µm or less, Al₂O₃ powder equivalent of 4N and having an average grain size of 5µm or less, and MgO powder equivalent of 4N and having an average grain size of 5µm or less were prepared. Subsequently, the ZnO powder and the Al₂O₃ powder were mixed to achieve the compounding ratio shown in Table 1, and the mixed powder was calcinated at a temperature of 1000°C to obtain AZO powder.

The foregoing AZO [powder] and the MgO powder were mixed to achieve the compounding ratio shown in Table 1, and further calcinated at a temperature of 1000°C. The obtained calcinated powder was pulverized with a ball mill or the like to an average grain size of 1µm or less, and thereafter granulated to increase the moldability. The granulated powder material was press molded at a pressure of 500kgf/cm².

After press molding, the resultant material was subject to pressureless sintering in an oxygen atmosphere at a temperature of 1400°C. This sintered material was formed into a target with machining process.

As a result of the above, the sputtering target of Example 3 achieved a relative density of 99% and a bulk resistance of 35m Ω · cm, and stable DC sputtering could be performed. In addition, the deposition speed achieved 2Å/sec, and showed favorable sputtering characteristics.

The transmission factor of the sputtered film achieved 98.5% (633nm), and the refractive index was 1.75.

Since the target of this Example does not use ZnS, there is no characteristic degradation in the optical information recording medium caused by the diffusion or contamination of sulfur. Further, in comparison to the Comparative Examples described later, the transmission factor, refractive index, target density and deposition speed of the deposition sample all showed favorable numerical values, and it was possible to perform DC sputtering.

### (Example 4)

ZnO powder equivalent of 4N and 5µm or less, Al₂O₃ powder equivalent of 4N and having an average grain size of 5µm or less, and SiO₂ powder equivalent of 4N and having an average grain size of 5µm or less were prepared. Subsequently, the ZnO powder and the Al₂O₃ powder were mixed to achieve the compounding ratio shown in Table 1, and the mixed powder was calcinated at a temperature of 1000°C to obtain AZO powder.

The foregoing AZO [powder] and the SiO₂ powder were mixed to achieve the compounding ratio shown in Table 1, and further calcinated at a temperature of 1000°C. The obtained calcinated powder was pulverized with a ball mill or the like to an average grain size of 1µm or less, and thereafter granulated to increase the moldability. The granulated powder material was press molded at a pressure of 500kgf/cm².

After press molding, the resultant material was subject to pressureless sintering in an oxygen atmosphere at a temperature of 1400°C. This sintered material was formed into a target with machining process.

As a result of the above, the sputtering target of Example 4 achieved a relative density of 99%, and stable DC sputtering could be performed. The bulk resistance was 45m Ω·cm, the deposition speed achieved 2.2Å/sec, and showed favorable sputtering characteristics. The transmission factor of the sputtered film achieved 99.4% (633nm), and the refractive index was 1.7.

Since the target of this Example does not use ZnS, there is no characteristic degradation in the optical information recording medium caused by the diffusion or contamination of sulfur. Further, in comparison to the Comparative Examples described later, the transmission factor, refractive index, target density and deposition speed of the deposition sample all showed favorable numerical values, and it was possible to perform DC sputtering.

### (Example 5)

ZnO powder equivalent of 4N and 5µm or less, Al₂O₃ powder equivalent of 4N and having an average grain size of 5µm or less, and SiO₂ powder and MgO powder equivalent of 4N and having an average grain size of 5µm or less were prepared. Subsequently, the ZnO powder and the Al₂O₃ powder were mixed to achieve the compounding ratio shown in Table 1, and the mixed powder was calcinated at a temperature of 1000°C to obtain AZO powder.

Meanwhile, the MgO powder equivalent of 4N and having an average grain size of 5µm or less and the SiO₂ powder equivalent of 4N and having an average grain size of 5µm or less were similarly mixed to achieve the compounding ratio shown in Table 1, and the mixed powder was further calcinated at a temperature of 1000°C.

Subsequently, the foregoing AZO powder and the calcinated powder of MgO powder and SiO₂ powder were further mixed and calcinated once again. The obtained calcinated powder was pulverized with a ball mill or the like to an average grain size of 1µm or less, and thereafter granulated to increase the moldability. The granulated powder material was press molded at a pressure of 500kgf/cm².

After press molding, the resultant material was subject to pressureless sintering in an oxygen atmosphere at a temperature of 1400°C. This sintered material was formed into a target with machining process.

The foregoing 6-inch φ size target subject to finish processing was used to perform sputtering. The sputtering conditions and evaluation method were the same as Example 1. The results are similarly shown in Table 1.

As a result of the above, the sputtering target of Example 5 achieved a relative density of 95%, and stable DC sputtering could be performed. The bulk resistance was 50m Ω·cm, the deposition speed achieved 1.9Å/sec, and showed favorable sputtering characteristics. The transmission factor of the sputtered film achieved 97.4% (633nm), and the refractive index was 1.78.

Since the target of this Example does not use ZnS, there is no characteristic degradation in the optical information recording medium caused by the diffusion or contamination of sulfur. Further, in comparison to the Comparative Examples described later, the transmission factor, refractive index, target density and deposition speed of the deposition sample all showed favorable numerical values, and it was possible to perform DC sputtering.

### (Example 6)

ZnO powder equivalent of 4N and 5µm or less, Al₂O₃ powder equivalent of 4N and having an average grain size of 5µm or less, and MgO powder equivalent of 4N and having an average grain size of 5µm or less were prepared. Subsequently, the ZnO powder and the Al₂O₃ powder were mixed to achieve the compounding ratio shown in Table 1, and the mixed powder was calcinated at a temperature of 1000°C to obtain AZO powder.

The foregoing AZO [powder] and the MgO powder were mixed to achieve the compounding ratio shown in Table 1, and further calcinated at a temperature of 1000°C. The obtained calcinated powder was pulverized with a ball mill or the like to an average grain size of 1µm or less, and thereafter granulated to increase the moldability. The granulated powder material was press molded at a pressure of 500kgf/cm².

After press molding, the resultant material was subject to pressureless sintering in an oxygen atmosphere at a temperature of 1400°C. This sintered material was formed into a target with machining process.

As a result of the above, the sputtering target of Example 6 achieved a relative density of 99% and a bulk resistance of 30m Ω·cm, and stable DC sputtering could be performed. In addition, the deposition speed achieved 2.2Å/sec, and showed favorable sputtering characteristics.

The transmission factor of the sputtered film achieved 95.8% (633nm), and the refractive index was 1.82. Incidentally, with Example 6, as shown in Table 1, since the MgO content is at the lower limit of the present invention at 1 at%, the transmission factor of the sputtered film decreased slightly, and the refractive index also increased slightly. Nevertheless, the transmission factor and refractive index in the foregoing range are able to obtain the target characteristics.

Since the target of this Example does not use ZnS, there is no characteristic degradation in the optical information recording medium caused by the diffusion or contamination of sulfur. Further, in comparison to the Comparative Examples described later, the transmission factor, refractive index, target density and deposition speed of the deposition sample all showed favorable numerical values, and it was possible to perform DC sputtering.

### (Example 7)

ZnO powder equivalent of 4N and 5µm or less, Al₂O₃ powder equivalent of 4N and having an average grain size of 5µm or less, and SiO₂ powder and MgO powder equivalent of 4N and having an average grain size of 5µm or less were prepared. Subsequently, the ZnO powder and the Al₂O₃ powder were mixed to achieve the compounding ratio shown in Table 1, and the mixed powder was calcinated at a temperature of 1000°C to obtain AZO powder.

Meanwhile, the MgO powder equivalent of 4N and having an average grain size of 5µm or less and the SiO₂ powder equivalent of 4N and having an average grain size of 5µm or less were similarly mixed to achieve the compounding ratio shown in Table 1, and the mixed powder was further calcinated at a temperature of 1000°C.

Subsequently, the foregoing AZO powder and the calcinated powder of MgO powder and SiO₂ powder were further mixed and calcinated once again. The obtained calcinated powder was pulverized with a ball mill or the like to an average grain size of 1µm or less, and thereafter granulated to increase the moldability. The granulated powder material was press molded at a pressure of 500kgf/cm².

After press molding, the resultant material was subject to pressureless sintering in an oxygen atmosphere at a temperature of 1400°C. This sintered material was formed into a target with machining process.

The foregoing 6-inch φ size target subject to finish processing was used to perform sputtering. The sputtering conditions and evaluation method were the same as Example 1. The results are similarly shown in Table 1.

As a result of the above, the sputtering target of Example 7 achieved a relative density of 95%, and stable DC sputtering could be performed. The bulk resistance was 30m Ω·cm, the deposition speed achieved 2.5Å/sec, and showed favorable sputtering characteristics.

The transmission factor of the sputtered film achieved 96.9% (633nm), and the refractive index was 1.82. Incidentally, with Example 7, as shown in Table 1, since the total content of MgO and SiO₂ is at the lower limit of the present invention at 1 at %, the transmission factor of the sputtered film decreased slightly, and the refractive index also increased slightly. Nevertheless, the transmission factor and refractive index in the foregoing range are able to obtain the target characteristics.

Since the target of this Example does not use ZnS, there is no characteristic degradation in the optical information recording medium caused by the diffusion or contamination of sulfur. Further, in comparison to the Comparative Examples described later, the transmission factor, refractive index, target density and deposition speed of the deposition sample all showed favorable numerical values, and it was possible to perform DC sputtering.

### (Example 8)

ZnO powder equivalent of 4N and 5µm or less, Al₂O₃ powder equivalent of 4N and having an average grain size of 5µm or less, and MgO powder equivalent of 4N and having an average grain size of 5µm or less were prepared. Subsequently, the ZnO powder, the Al₂O₃ powder and MgO powder were mixed to achieve the compounding ratio shown in Table 1, and the mixed powder was calcinated at a temperature of 1000°C.

The obtained calcinated powder was pulverized with a ball mill or the like to an average grain size of 1µm or less, and thereafter granulated to increase the moldability. The granulated powder material was press molded at a pressure of 500kgf/cm². After press molding, the resultant material was subject to pressureless sintering in an oxygen atmosphere at a temperature of 1400°C. This sintered material was formed into a target with machining process.

As a result of the above, the sputtering target of Example 8 achieved a relative density of 99% and a bulk resistance of 120m Ω ·cm. Since DC sputtering could not be performed, RF (Radio Frequency) sputtering was performed. The deposition speed achieved 0.9Å/sec and was slightly inferior in comparison to DC sputtering, but it was faster than the standard sputtering speed.

The transmission factor of the sputtered film achieved 97.5% (633nm), and the refractive index was 1.74, and both showed favorable results.

Since the target of this Example does not use ZnS, there is no characteristic degradation in the optical information recording medium caused by the diffusion or contamination of sulfur, Further, in comparison to the Comparative Examples described later, the transmission factor, refractive index, and target density of the deposition sample all showed favorable numerical values. Although the bulk resistance and deposition speed were somewhat inferior, they showed favorable values in comparison to the Comparative Examples described later.

### (Example 9)

ZnO powder equivalent of 4N and 5µm or less, Al₂O₃ powder equivalent of 4N and having an average grain size of 5µm or less, and SiO₂ powder and MgO powder equivalent of 4N and having an average grain size of 5µm or less were prepared. Foremost, the ZnO powder, Al₂O₃ powder, SiO₂ powder and MgO powder were mixed to achieve the compounding ratio shown in Table 1, and the mixed powder was calcinated at a temperature of 1000°C.

Subsequently, the ZnO powder, Al₂O₃ powder, MgO powder and SiO₂ powder were pulverized with a ball mill or the like to an average grain size of 1µm or less, and thereafter granulated to increase the moldability. The granulated powder material was press molded at a pressure of 500kgf/cm².

After press molding, the resultant material was subject to pressureless sintering in an oxygen atmosphere at a temperature of 1400°C. This sintered material was formed into a target with machining process. The foregoing 6-inch φ size target subject to finish processing was used to perform sputtering. The sputtering conditions and evaluation method were the same as Example 1. The results are similarly shown in Table 1.

As a result of the above, the sputtering target of Example 9 achieved a relative density of 95% and a bulk resistance of 250m Ω ·cm. Since DC sputtering could not be performed, RF (Radio Frequency) sputtering was performed. The deposition speed achieved 0.8Å/sec and was slightly inferior in comparison to DC sputtering, but it was faster than the standard sputtering speed.

The transmission factor of the sputtered film achieved 98.8% (633nm), and the refractive index was 1.7, and both showed favorable results. Since the target of this Example does not use ZnS, there is no characteristic degradation in the optical information recording medium caused by the diffusion or contamination of sulfur. Further, in comparison to the Comparative Examples described later, the transmission factor, refractive index, target density and deposition speed of the deposition sample all showed favorable numerical values, and it was possible to perform DC sputtering.

### (Comparative Example 1)

As shown in Table 1, materials having components and compositions of raw material powder that are different from the conditions of the present invention were prepared; specifically, ZnO powder equivalent of 4N and 5µm or less, and Al₂O₃ powder equivalent of 4N and having an average grain size of 5µm or less were prepared. Subsequently, the ZnO powder and the Al₂O₃ powder were mixed to achieve the compounding ratio shown in Table 1, and the mixed powder was calcinated at a temperature of 1000°C.

The obtained calcinated powder was pulverized with a ball mill or the like to an average grain size of 1µm or less, and thereafter granulated to increase the moldability. The granulated powder material was press molded at a pressure of 500kgf/cm². After press molding, the resultant material was subject to pressureless sintering in an oxygen atmosphere at a temperature of 1400°C. This sintered material was formed into a target with machining process.

As a result of the above, the sputtering target of Comparative Example 1 achieved a relative density of 99% and a bulk resistance of 20m Ω ·cm, and DC sputtering was performed. The deposition speed was favorable at 2.2 Å/sec. Nevertheless, although the transmission factor of the sputtered film was favorable at 97.5% (633nm), the refractive index was extremely high at 1.84, and it could not be said that a favorable film was obtained. The results are similarly shown in Table 1.

### (Comparative Example 2)

As shown in Table 1, ZnO powder equivalent of 4N and 5µm or less, Al₂O₃ powder equivalent of 4N and having an average grain size of 5µm or less, and MgO powder equivalent of 4N and having an average grain size of 5µm or less were prepared. Subsequently, the ZnO powder and the Al₂O₃ powder were mixed to achieve the compounding ratio shown in Table 1, and the mixed powder was calcinated at a temperature of 1000°C to obtain AZO powder.

The foregoing AZO powder and the MgO powder were mixed to achieve the compounding ratio shown in Table 1 (this compounding ratio exceeds the conditions of the present invention where excessive MgO powder is added), and further calcinated at a temperature of 1000°C. The obtained calcinated powder was pulverized with a ball mill or the like to an average grain size of 1µm or less, and thereafter granulated to increase the moldability.

The granulated powder material was press molded at a pressure of 500kgf/cm². After press molding, the resultant material was subject to pressureless sintering in an oxygen atmosphere at a temperature of 1400°C. This sintered material was formed into a target with machining process.

As a result of the above, the sputtering target of Comparative Example 2 achieved a relative density of 99%, but the bulk resistance was 450m Ω ·cm. Since DC sputtering could not be performed, RF (Radio Frequency) sputtering was performed. The deposition speed was 0.4Å/sec, and resulted in a significantly inferior deposition speed.

### (Comparative Example 3)

As shown in Table 1, ZnO powder equivalent of 4N and 5µm or less, Al₂O₃ powder equivalent of 4N and having an average grain size of 5µm or less, and SiO₂ powder and MgO powder equivalent of 4N and having an average grain size of 5µm or less were prepared. Subsequently, the ZnO powder and the Al₂O₃ powder were wet-mixed and dried to achieve the compounding ratio shown in Table 1, and the mixed powder was calcinated at a temperature of 1000°C to obtain AZO powder.

Meanwhile, the MgO powder equivalent of 4N and having an average grain size of 5µm or less and the SiO₂ powder equivalent of 4N and having an average grain size of 5µm or less were similarly mixed to achieve the compounding ratio shown in Table 1, and the mixed powder was further calcinated at a temperature of 1000°C.

Subsequently, the foregoing AZO powder and the calcinated powder of MgO powder and SiO₂ powder were further mixed and calcinated once again. The obtained calcinated powder was pulverized with a ball mill or the like to an average grain size of 1µm or less, and thereafter granulated to increase the moldability. The granulated powder material was press molded at a pressure of 500kgf/cm². The compounding ratio of the foregoing AZO powder and the calcinated powder of MgO powder and SiO₂ powder exceeds the conditions of the present invention where the total amount of MgO powder and SiO₂ powder is excessively added.

After press molding, the resultant material was subject to pressureless sintering in an oxygen atmosphere at a temperature of 1400°C. This sintered material was formed into a target with machining process.

As a result of the above, the sputtering target of Comparative Example 3 achieved a relative density of 99%, but the bulk resistance was 750m Ω ·cm. Since DC sputtering could not be performed, RF (Radio Frequency) sputtering was performed. The deposition speed was 0.5Å/sec, and resulted in a significantly inferior deposition speed.

### INDUSTRIAL APPLICABILITY

Since the thin film formed by using a sputtering target of the present invention forms a part of the structure of the optical information recording medium and does not use ZnS, it yields a significant effect in that diffusion of the sulfur constituent to the recording layer material will not occur, and deterioration of the recording layer can be prevented thereby.

Further, as a semitransparent layer that does not entail such problem of sulfurization, it is possible to use a semitransparent layer having arbitary optical characteristics by alternately laminating a high refractive index layer and a low refractive index layer. The target of the present invention may also be preferably used as a low refractive index layer configuring the semitransparent layer.

Further, in addition to the amorphous nature becoming stabilized, the target will be provided with conductivity, sintering with a relatively low temperature will be enabled, and the target can thereby be manufactured stably. Moreover, since it is possible to make the relative density a high density of 95% or higher, stable RF sputtering is enabled.

Another significant feature of the present invention is that the target bulk resistance is reduced, conductivity is provided, and stable DC sputtering is enabled depending on the material through raising the relative density to 90% or higher. In addition, there is a significant effect in that the controllability of sputtering can be facilitated, the deposition speed can be increased, and the sputtering efficiency can also be improved. RF sputtering may be performed as necessary and, even in such a case, improvement in the deposition speed was confirmed.

Further still, there is significant effect in that it is possible to reduce the particles (dust) or nodules arising during sputtering upon performing deposition, improve the mass productivity with little variation in quality, and stably manufacture an optical recording medium having an optical disk protective film at low costs. Thus, the present invention is extremely useful for forming an optical thin film.

## Claims

1. A sputtering target comprised of 0.2 to 3.0 at% of Al₂O₃, 1 to 27 at% of MgO and/or SiO₂, and remnant ZnO, and having a low bulk resistance.

2. The sputtering target according to claim 1, wherein the MgO and/or SiO₂ content is 10 to 27 at%.

3. The sputtering target according to claim 1 or claim 2, wherein the relative density is 90% or higher.

4. The sputtering target according to any one of claims 1 to 3, wherein said sputtering target is used as a target for forming a protective layer, a reflective layer or a semitransparent layer of an optical information recording medium.

5. The sputtering target according to any one of claims 1 to 3, wherein the bulk resistance of the target is less than 100m Ω ·cm.

6. A manufacturing method of a sputtering target having a low bulk resistance, wherein the overall content of said sputtering target is 0.2 to 3.0 at% of Al₂O₃, 1 to 27 at% of MgO and/or SiO₂, and remnant ZnO, the method comprising the steps of preliminarily mixing and preliminarily calcinating Al₂O₃ powder and ZnO powder as the raw material, subsequently mixing MgO and/or SiO₂ powder to the calcinated Al₂O₃-ZnO mixed powder, calcinating the obtained powder once again, and thereafter sintering said obtained powder.

7. A manufacturing method of a sputtering target having a low bulk resistance, wherein the overall content of said sputtering target is 0.2 to 3.0 at% of Al₂O₃, 1 to 27 at% of MgO and/or SiO₂, and remnant ZnO, the method comprising the steps of preliminarily mixing and preliminarily calcinating Al₂O₃ powder and ZnO powder as the raw material, similarly mixing and calcinating MgO powder and SiO₂ powder as the raw material, subsequently mixing the MgO-SiO₂ calcinated powder to said calcinated Al₂O₃-ZnO powder, calcinating the obtained powder once again, and thereafter sintering said obtained powder.

8. The manufacturing method of a sputtering target according to claim 6 or 7, wherein the MgO and/or SiO₂ content is 10 to 27 at%.

## Patentansprüche

1. Sputter-Target, das 0,2 bis 3,0 Gew.-% Al₂O₃, 1 bis 27 Gew.-% MgO und/oder SiO₂ und restlichesZnO umfasst und einen geringen spezifischen Volumenwiderstand aufweist.

2. Sputter-Target nach Anspruch 1, wobei der MgO- und/oder SiO₂-Gehalt 10 bis 27 Gew.-% beträgt.

3. Sputter-Target nach Anspruch 1 oder 2, wobei die spezifische Dichte 90 % oder mehrbeträgt.

4. Sputter-Target nach einem der Ansprüche 1 bis 3, wobei das Sputter-Target als Target zum Bilden einer Schutzschicht, einer reflektierenden Schicht oder einer halbtransparenten Schicht eines optischen Datenaufzeichnungsmediums verwendet wird.

5. Sputter-Target nach einem der Ansprüche 1 bis 3, wobei der spezifische Volumenwiderstand des Targets weniger als 100 MΩ/cm beträgt.

6. Herstellungsverfahren für ein Sputter-Target mit geringem spezifischen Volumenwiderstand, wobei das Sputter-Target insgesamt 0,2 bis 3,0 Gew.-% Al₂O₃, 1 bis 27 Gew.-% MgO und/oder SiO₂ und restlichesZnO enthält, wobei das Verfahren die Schritte des vorab erfolgenden Mischens und vorab erfolgenden Kalzinierens des Al₂O₃-Pulvers und des ZnO-Pulvers als Rohmaterial, des nachfolgenden Zumischens des MgO- und /oder SiO₂-Pulvers zum kalzinierten Al₂O₃-ZnO-Mischpulver, des erneuten Kalzinierens des gewonnenen Pulvers und des darauf folgenden Sinterns des gewonnenen Pulvers umfasst.

7. Herstellungsverfahren für ein Sputter-Target mit geringem spezifischen Volumenwiderstand, wobei das Sputter-Target insgesamt 0,2 bis 3,0 Gew.-% Al₂O₃, 1 bis 27 Gew.-% MgO und/oder SiO₂ und restlichesZnO enthält, wobei das Verfahren die Schrittedes vorab erfolgenden Mischens und vorab erfolgenden Kalzinierens des Al₂O₃-Pulvers und des ZnO-Pulvers als Rohmaterial, des Mischens und Kalzinierens des MgO-Pulvers und des SiO₂-Pulvers in ähnlicher Weise als Rohmaterial, des nachfolgenden Zumischens des kalzinierten MgO-SiO₂-Pulvers zum kalzinierten Al₂O₃-Pulver, des erneuten Kalzinierens des gewonnenen Pulvers und des darauf folgenden Sinterns des gewonnenen Pulvers umfasst.

8. Herstellungsverfahren für ein Sputter-Target nach Anspruch 6 oder 7, wobei der MgO- und/oder SiO₂-Gehalt 10 bis 27 Gew.-% beträgt.

## Revendications

1. Une cible de pulvérisation comprenant de 0,2 à 3,0 % at. d'Al₂O₃, de 1 à 27 % at. de MgO et/ou de SiO₂ et le reste du ZnO, et ayant une résistance volumique faible.

2. La cible de pulvérisation conformément à la revendication 1, dans laquelle la teneur en MgO et/ou SiO₂ se situe entre 10 et 27 % at.

3. La cible de pulvérisation conformément à la revendication 1 ou 2, dans laquelle la densité relative est de 90 % ou plus.

4. La cible de pulvérisation conformément à n'importe laquelle des revendications 1 à 3, dans laquelle ladite cible de pulvérisation est utilisée en tant que cible pour former une couche protectrice, une couche réfléchissante ou une couche semi-transparente d'un support optique d'enregistrement des données.

5. La cible de pulvérisation conformément à n'importe laquelle des revendications 1 à 3, dans laquelle la résistance volumique de la cible est inférieure à 100 m Ω · cm.

6. Une méthode de fabrication d'une cible de pulvérisation ayant une résistance volumique faible et ayant une teneur totale de 0,2 à 3,0 % at. d'Al₂O₃ de 1 à 27 % at. de MgO et/ou de SiO₂ et le reste du ZnO, la méthode se composant des étapes suivantes : mélanger et calciner la poudre d'Al₂O₃ et la poudre de ZnO en tant que matière première, mélanger la poudre de MgO et/ou de SiO₂ avec le mélange de poudre d'Al₂O₃-ZnO calcinée, calciner une nouvelle fois la poudre obtenue et fritter la poudre ainsi obtenue.

7. Une méthode de fabrication d'une cible de pulvérisation ayant une résistance volumique faible et ayant une teneur totale de 0,2 à 3,0 % at. d'Al₂O₃, de 1 à 27 % at. de MgO et/ou de SiO₂ et le reste du ZnO, la méthode se composant des étapes suivantes : mélanger et calciner la poudre d'Al₂O₃ et la poudre de ZnO en tant que matière première, mélanger et calciner la poudre de MgO et la poudre de SiO₂ en tant que matière première, mélanger la poudre calcinée de MgO-SiO₂ avec la poudre calcinée d'Al₂O₃-ZnO, calciner une nouvelle fois la poudre obtenue et fritter la poudre ainsi obtenue.

8. La méthode de fabrication d'une cible de pulvérisation conformément à la revendication 6 ou 7, dans laquelle la teneur en MgO et/ou SiO₂ se situe entre 10 et 27 % at.
